# EUROPEAN PATENT APPLICATION

(11) **EP 2 144 288 A2**
(43) Date of publication of application: **13.01.2010**
(21) Application number: 09162817.2
(22) Date of filing: 16.06.2009
(51) Int. Cl.: H01L 27/146

(54) **Process for Producing Optical Component**

(30) Priority: 17.06.2008 JP 2008157938
(71) Applicant: NITTO DENKO CORPORATION, Osaka (JP)
(72) Inventor: Noro, Hiroshi, Ibaraki-shi Osaka (JP); Nakahashi, Akiko, Ibaraki-shi Osaka (JP); Ito, Hisataka, Ibaraki-shi Osaka (JP)
(74) Representative: Grünecker, Kinkeldey, Stockmair & Schwanhäusser Anwaltssozietät

(57) **Abstract**

The present invention relates to a process for producing an optical component, the process including: disposing a transparent stamp tool on a substrate or an imaging element through a transparent ultraviolet-curable resin composition layer; and irradiating the resin composition layer with an ultraviolet ray through the transparent stamp tool to thereby cure the resin composition layer, in which a resin composition contained in the resin composition layer contains a thermosetting resin as a main component and a photo-acid generator, and the ultraviolet ray passing through the transparent stamp tool is an ultraviolet ray having a wavelength of 320 nm or more.

## Description

### FIELD OF THE INVENTION

The present invention relates to a process for producing an optical component, and more particularly relates to a process for producing an optical component such as an optical lens, an optical recording medium or an imaging device.

### BACKGROUND OF THE INVENTION

In small-size cameras mounted on cellular phones or the like, CCD or CMOS image sensors (solid imaging devices) have been widely used. This small-size camera is generally assembled from respective constituent elements such as an imaging element, an infrared cut filter, an optical lens and a lens holder. With respect to such a camera, as one of needs associated with an increase in resolution, there is a decrease in noise by preventing contamination with dust and the like adhered to the imaging element. In general, in order to decrease noise caused by contamination with dust and the like, there has been taken a countermeasure that a protecting plate such as Pyrex (registered trade mark) glass is provided on the imaging element to decrease contamination with dust and the like adhered to a surface of the element. Systems for providing the protecting plate on the imaging element include a conventional system of applying an adhesive onto the imaging element or the protecting plate in a picture frame form in an outer frame dimension shape of a photodiode alignment (pixel) of the imaging element, and mounting the protecting plate on the imaging element through the adhesive per se or a spacer. Further, there are needs for simplifying production processes and improving productivity. In order to meet the needs, there has recently been studied, for example, a system of applying a transparent ultraviolet-curable adhesive all over the protecting plate, and then, adhering the adhesive-applied surface to the imaging element to form a protective layer on the imaging element (for example, see JP-B-61-22865).

However, the above-mentioned transparent ultraviolet-curable adhesive is liable to cause problems such as discoloration and fluctuations in optical characteristics and mechanical characteristics by heat of a use environment after curing. It has been therefore difficult to produce the imaging device having both productivity and resolution quality by employing the above-mentioned system.

On the other hand, when optical components such as optical lenses and optical recording media are produced, the production thereof by an imprint system has been studied as a need associated with an increase in density, an increase in heat resistance or a reduction in production cost. The imprint systems include, for example, a system of heat melting a thermoplastic resin composition and press fitting a forming mold thereto, thereby obtaining a formed material having a specific shape; and a system of pressing a forming mold to an ultraviolet-curable resin composition and then irradiating the resin composition with an ultraviolet ray, thereby obtaining a formed material having a specific shape. Above all, in order to obtain the optical component requiring heat resistance to environmental heat of solder reflow or the like, the above-mentioned system using the ultraviolet-curable resin composition as a material has been considered to be desirable, in that strain due to thermal expansion is hard to occur, which makes it possible to perform high-accuracy pattern formation.

However, even when the optical component is produced in such a manner, there is a problem that a cured product of the above-mentioned ultraviolet-curable resin composition is liable to cause discoloration, fluctuations in optical characteristics and mechanical characteristics and the like by heat.

### SUMMARY OF THE INVENTION

The invention has been made in view of such circumstances, and an object thereof is to provide a process for producing an optical component, which can provide the optical component having high transparency and heat resistance reliability without resin discoloration even when the ultraviolet-curable resin composition is used, and can meet needs for simplifying a production process of the optical component and improving productivity.

In order to achieve the above-mentioned object, the process for producing an optical component of the invention is a process for producing an optical component, which includes disposing a transparent stamp tool on a substrate or an imaging element through a transparent ultraviolet-curable resin composition layer and irradiating the resin composition layer with an ultraviolet ray through the transparent stamp tool to thereby cure the resin composition layer, in which a resin composition contained in the resin composition layer contains a thermosetting resin as a main component and a photo-acid generator, and the ultraviolet ray passing through the transparent stamp tool is an ultraviolet ray having a wavelength of 320 nm or more.

That is to say, in order to solve the above-mentioned problems, the present inventors have made intensive studies. In the course of the studies, it has been conceived to form the transparent ultraviolet-curable resin composition layer on the substrate or the imaging element by dropping or the like of the resin composition, to further dispose the transparent stamp tool thereon in an adhered state, and to irradiate the above-mentioned resin composition with an ultraviolet ray through the above-mentioned transparent stamp tool to thereby cure the above-mentioned resin composition. Then, as the above-mentioned resin composition, there has been used a resin composition containing a thermosetting resin as a main component and a photo-acid generator (one which generates a cation-polymerizable acid by ultraviolet irradiation). Further, as the above-mentioned transparent stamp tool, there has been used one having such characteristics (filter function) that the ultraviolet ray passing through the transparent stamp tool per se is an ultraviolet ray having a wavelength of 320 nm or more. As a result, it has been found that the optical component having high transparency and heat resistance reliability without resin discoloration can be produced even when the ultraviolet-curable resin is used, thus arriving at the invention.

Namely, the present invention relates to the following items (1) to (11).
(1) A process for producing an optical component, the process including:
   disposing a transparent stamp tool on a substrate or an imaging element through a transparent ultraviolet-curable resin composition layer; and
   irradiating the resin composition layer with an ultraviolet ray through the transparent stamp tool to thereby cure the resin composition layer,
   in which a resin composition contained in the resin composition layer contains a thermosetting resin as a main component and a photo-acid generator, and the ultraviolet ray passing through the transparent stamp tool is an ultraviolet ray having a wavelength of 320 nm or more.
(2) The process for producing an optical component according to (1), in which the transparent stamp tool is a forming mold in which a mold surface thereof has a concave-convex pattern, and in which the transparent ultraviolet-curable resin composition layer is cured by irradiation of the ultraviolet ray, and then, the concave-convex pattern is transferred to the resin composition layer by demolding the forming mold.
(3) The process for producing an optical component according to (1), in which the transparent stamp tool is a transparent protecting plate for the imaging element, and in which the transparent ultraviolet-curable resin composition layer is cured by irradiation of the ultraviolet ray, and the imaging element is integrated with the transparent protecting plate by curing the resin composition layer.
(4) The process for producing an optical component according to any one of (1) to (3), in which the transparent stamp tool allows an ultraviolet ray having a wavelength of 320 nm or more to pass therethrough and prevents an ultraviolet ray having a wavelength of less than 320 nm from passing therethrough.
(5) The process for producing an optical component according to (4), in which the transparent stamp tool has an ultraviolet ray transmittance at a wavelength of less than 320 nm of less than 5%.
(6) The process for producing an optical component according to any one of (1) to (5), in which the transparent stamp tool is composed of a silicone resin or polymethyl methacrylate.
(7) The process for producing an optical component according to any one of (1) to (6), in which the transparent stamp tool is composed of a transparent resin containing at least one of an ultraviolet absorber and an antioxidant.
(8) The process for producing an optical component according to any one of (1) to (5), in which the transparent stamp tool includes a glass bass, and a sputtering layer provided on a surface of the glass base and composed of at least one of cerium oxide, titanium oxide and zinc oxide.
(9) The process for producing an optical component according to any one of (1) to (8), in which the substrate is a transparent substrate, and the transparent ultraviolet-curable resin composition layer is irradiated with the ultraviolet ray having a wavelength of 320 nm or more through the transparent substrate.
(10) The process for producing an optical component according to (9), in which the transparent substrate allows an ultraviolet ray having a wavelength of 320 nm or more to pass therethrough and prevents an ultraviolet ray having a wavelength of less than 320 nm from passing therethrough.
(11) The process for producing an optical component according to any one of (1) to (10), in which the transparent ultraviolet-curable resin composition layer is cured by irradiation of the ultraviolet ray, and then, the cured product is subjected to heat treatment at 70°C or more.

As described above, the process for producing an optical component of the invention is a process for producing an optical component, which includes: disposing a transparent stamp tool on a substrate or an imaging element through a transparent ultraviolet-curable resin composition layer; and irradiating the above-mentioned resin composition layer with an ultraviolet ray through the above-mentioned transparent stamp tool to thereby cure the above-mentioned resin composition layer, in which a resin composition of the above-mentioned resin composition layer contains a thermosetting resin as a main component and a photo-acid generator, and the ultraviolet ray passing through the above-mentioned transparent stamp tool is an ultraviolet ray having a wavelength of 320 nm or more. By this production process, the transparent ultraviolet-curable resin composition constituting the above-mentioned resin composition layer cures without discoloration to give high transparency and heat resistance reliability, and therefore, it can meet needs for simplifying a production process of the optical component and improving productivity.

Then, the above-mentioned transparent stamp tool is a forming mold in which a mold surface thereof has a concave-convex pattern, the transparent ultraviolet-curable resin composition layer is cured by the above-mentioned ultraviolet irradiation, and then, the concave-convex pattern is transferred to the above-mentioned resin composition layer by demolding the above-mentioned forming mold. In this case, the optical component such as an optical lens or an optical recording medium can be efficiently produced.

Further, the above-mentioned transparent stamp tool is a transparent protecting plate for the imaging element, the transparent ultraviolet-curable resin composition layer is cured by the above-mentioned ultraviolet irradiation, and the imaging element is integrated with the above-mentioned transparent protecting plate by curing the resin composition layer. In this case, the optical component such as an imaging device can be efficiently produced.

### BRIEF DESCRIPTION OF THE DRAWINGS

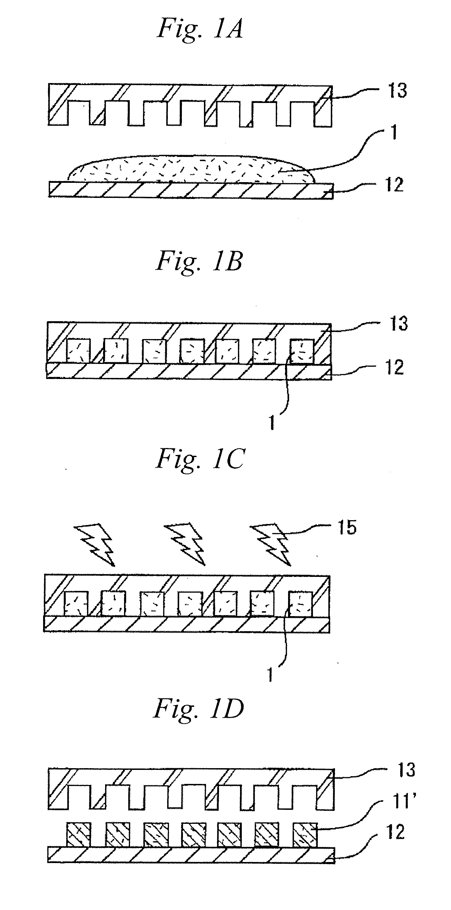

Figs. 1 are illustrative views showing one example of a production process of an optical component of the invention, Fig. 1A shows a state where potting of a transparent ultraviolet-curable resin composition is performed on a substrate, Fig. 1B shows a state where the resin composition is filled in a forming mold by pressing the forming mold, Fig. 1C shows a state where the resin composition filled is irradiated with an ultraviolet ray, and Fig. 1D shows a state where the optical component is demolded from the mold.

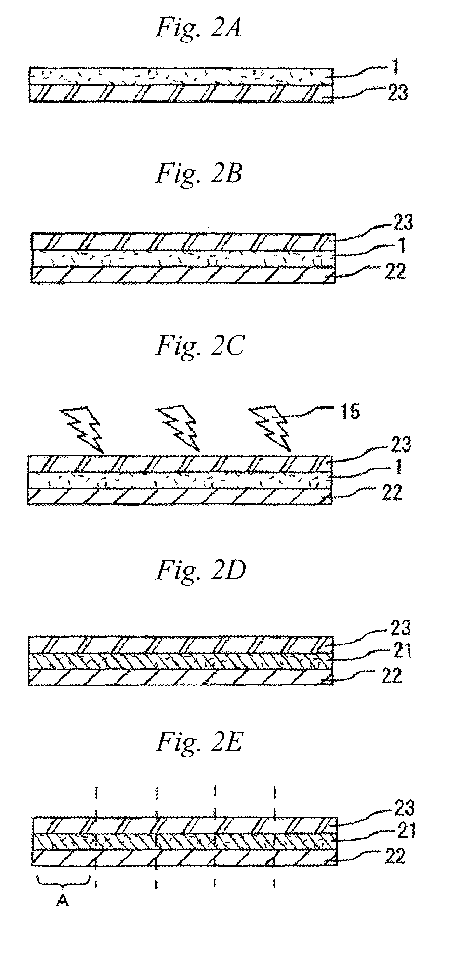

Figs. 2 are illustrative views showing another example of a production process of an optical component of the invention, Fig. 2A shows a state where a film of a transparent ultraviolet-curable resin composition is formed on a transparent protecting plate, Fig. 2B shows a state where the transparent protecting plate is stuck onto an imaging element, Fig. 2C shows a state where the resin composition is cured by ultraviolet irradiation, Fig. 2D shows a state where the resin composition is completely cured, and Fig. 2E shows a state where this is cut to form each piece.

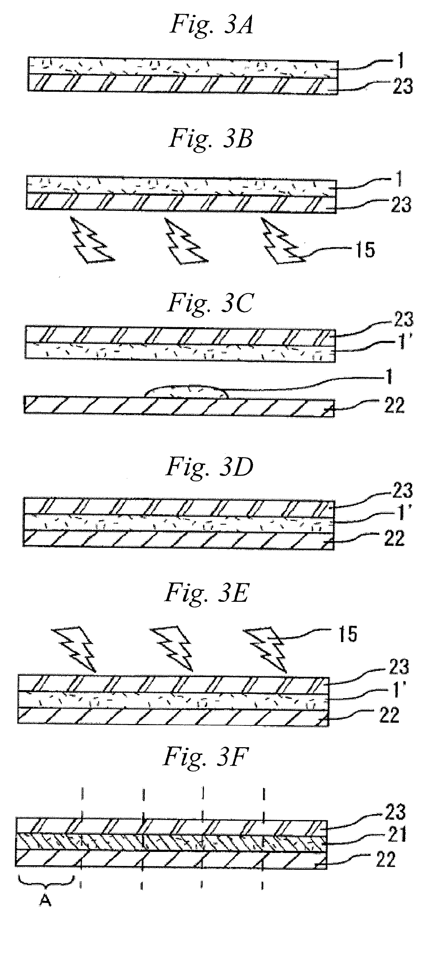

Figs. 3 are illustrative views showing still another example of a production process of an optical component of the invention, Fig. 3A shows a state where a film of a transparent ultraviolet-curable resin composition is formed on a transparent protecting plate, Fig. 3B shows a state where the resin composition is semicured by ultraviolet irradiation, Fig. 3C shows a state where the transparent protecting plate is to be stuck onto an imaging element, Fig. 3D shows a state where the transparent protecting plate is stuck onto the imaging element, Fig. 3E shows a state where the resin composition is completely cured by ultraviolet irradiation, and Fig. 3F shows a state where this is cut to form each piece.

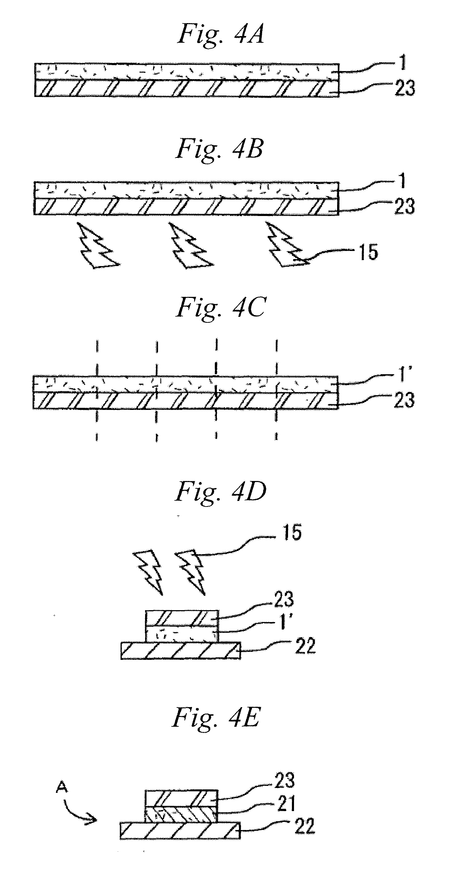

Figs. 4 are illustrative views showing a further example of a production process of an optical component of the invention, Fig. 4A shows a state where a film of a transparent ultraviolet-curable resin composition is formed on a transparent protecting plate, Fig. 4B shows a state where the resin composition is semicured by ultraviolet irradiation, Fig. 4C shows a state where this is cut to form each piece, Fig. 4D shows a state where the transparent protecting plate cut to form each piece is stuck onto an imaging element and irradiated with an ultraviolet ray, and Fig. 4E shows a state where the resin composition is completely cured by ultraviolet irradiation.

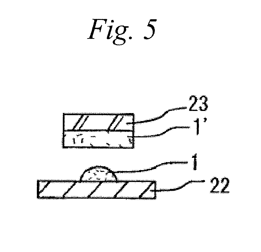

Fig. 5 is an illustrative view showing a production process (one step) of an optical component of the invention.

### DETAILED DESCRIPTION OF THE INVENTION

Embodiments of the invention will be described in detail below.

As described above, the process for producing an optical component of the invention is a process for producing an optical component, which includes: disposing a transparent stamp tool on a substrate or an imaging element through a transparent ultraviolet-curable resin composition layer; and irradiating the above-mentioned resin composition layer with an ultraviolet ray through the above-mentioned transparent stamp tool to thereby cure the above-mentioned resin composition layer, in which a resin composition of the above-mentioned resin composition layer contains a thermosetting resin as a main component and a photo-acid generator, and the ultraviolet ray passing through the above-mentioned transparent stamp tool is an ultraviolet ray having a wavelength of 320 nm or more. The term "main component" as used herein is a component which exerts a great influence on characteristics of the composition, and generally means a component which accounts for 50% by weight or more of the whole composition.

For example, when the optical component such as an optical lens or an optical recording medium is produced by the above-mentioned production process, the forming mold in which the mold surface thereof has the concave-convex pattern is used as the above-mentioned transparent stamp tool, the transparent ultraviolet-curable resin composition layer is cured by the above-mentioned ultraviolet irradiation, and then, the concave-convex pattern is transferred to the above-mentioned resin composition layer by demolding the above-mentioned forming mold. In this case, the optical component such as the optical lens obtained by transferring the concave-convex pattern can be obtained. Specifically, as shown in Fig. 1A, potting (resin application) of the above-mentioned transparent ultraviolet-curable resin composition 1 is first performed on a substrate 12 to form a resin composition layer, and a forming mold 13 is pressed thereon, thereby filling the resin composition 1 into concave portions of the concave-convex pattern of the mold surface as shown in Fig. 1B. Thereafter, the above-mentioned filled resin composition 1 is irradiated with an ultraviolet ray 15 having a wavelength of 320 nm or more through the above-mentioned forming mold 13 to cure the resin composition as shown in Fig. 1C, and a resin cured material 11' used as an optical lens or the like is demolded from the mold as shown in Fig. 1D. In this way, the resin cured material 11' which is used as an optical lens or the like and has been formed by transfer of the concave-convex pattern of the above-mentioned forming mold 13 is obtained on the substrate 12. This resin cured material 11' is dismounted from the above-mentioned substrate 12, and can be used as the optical component such as an optical lens as described above. Further, the above-mentioned resin cured material 11' is integrated with the substrate 12, and appropriately cut for each resin cured material, thereby also being able to obtain a hybrid lens or an optical recording medium.

Incidentally, when the resin cured material 11' used as an optical lens or the like is dismounted from the above-mentioned substrate 12 to use, a release sheet such as a PET film, a PP film, a PTFE film or a ETFE film is used as the above-mentioned substrate 12. Further, the concave-convex pattern can be directly formed on the mold surface of the above-mentioned forming mold 13 by laser processing, drilling, etching using a photolithography process, or the like, or can be formed by injection molding or transfer molding a transparent resin or glass material in a previously pattern-formed metal mold.

Further, for example, when the optical component such as an imaging device is produced by the above-mentioned production process, a transparent protecting plate for an imaging element is used as the transparent stamp tool used in the production process. The above-mentioned transparent protecting plate is disposed on the imaging element through the transparent ultraviolet-curable resin composition layer, and the above-mentioned resin composition layer is irradiated with the ultraviolet ray through the transparent protecting plate in that state to cure the transparent ultraviolet-curable resin composition layer. The imaging element is integrated with the above-mentioned transparent protecting plate by curing. In this way, the desired optical component can be obtained. Specifically, the above-mentioned transparent ultraviolet-curable resin composition 1 is first formed to a film having a predetermined thickness on a transparent protecting plate 23 as shown in Fig. 2A. Thereafter, as shown in Fig. 2B, a layer surface of the above-mentioned resin composition 1 is stuck onto an imaging element 22 to mount the transparent protecting plate 23 on the imaging element 22. After the above-mentioned sticking, the resin composition is irradiated with the ultraviolet ray 15 having a wavelength of 320 nm or more to completely cure the above-mentioned resin composition 1 as shown in Fig. 2C, thereby obtaining a resin cured product 21 as shown in Fig. 2D. Then, the above-mentioned resin cured product 21 is subjected to heat curing, and cut (diced) at portions indicated by broken lines as shown in Fig. 2E to form each piece, thus resulting in obtaining each imaging device A (optical component). Incidentally, the above-mentioned heat curing may be performed after the cutting (dicing) which is previously performed to obtain each imaging device. Further, when the heat curing is performed as described above, heat treatment is preferably conducted at 70°C or more in order to improve a heat resistance reliability.

Further, the optical component such as the imaging device can also be produced, for example, in the following manner. That is to say, the above-mentioned transparent ultraviolet-curable resin composition 1 is first formed to a film having a predetermined thickness on the transparent protecting plate 23 as shown in Fig. 3A. Thereafter, as shown in Fig. 3B, the above-mentioned resin composition 1 is irradiated with the ultraviolet ray 15 having a wavelength of 320 nm or more through the above-mentioned transparent protecting plate 23 to semicure the resin composition, in order to inhibit fluidity of the above-mentioned transparent ultraviolet-curable resin composition 1 at the time when the transparent protecting plate 23 is mounted. Thereafter, as shown in Fig. 3C, a layer surface of this semicured resin composition 1' is stuck onto the imaging element 22 to mount the transparent protecting plate 23 on the imaging element 22. At this time, in order to enhance sticking properties, a small amount of the transparent ultraviolet-curable resin composition 1 may be previously dropped on the imaging element 22 before the above-mentioned sticking as shown in Fig. 3C. Then, after the above-mentioned sticking, a laminate as shown in Fig. 3D is obtained, and this laminate is irradiated with the ultraviolet ray 15 having a wavelength of 320 nm or more to completely cure the above-mentioned resin composition 1' as shown in Fig. 3E, thereby obtaining a resin cured product 21. Further, as shown in Fig. 3F, this is cut at portions indicated by broken lines to form each piece, thus resulting in obtaining a desired imaging device A (optical component). Incidentally, the above-mentioned heat curing may be performed either after the above-mentioned ultraviolet irradiation or after cutting to each imaging device as described above, according to the necessity.

Further, the optical component such as the imaging device can also be produced in the following manner. That is to say, the above-mentioned transparent ultraviolet-curable resin composition 1 is first formed to a film having a predetermined thickness on the transparent protecting plate 23 as shown in Fig. 4A. Thereafter, as shown in Fig. 4B, the above-mentioned resin composition 1 is irradiated with the ultraviolet ray 15 having a wavelength of 320 nm or more through the above-mentioned transparent protecting plate 23 to semicure the resin composition. This is cut at portions indicated by broken lines to form each piece as shown in Fig. 4C. A surface of this semicured resin composition 1' is stuck onto the imaging element 22 as shown in Fig. 4D, followed by further irradiation with the ultraviolet ray 15 having a wavelength of 320 nm or more to completely cure the above-mentioned resin composition 1', thereby obtaining a resin cured product 21. This can integrate the above-mentioned transparent protecting plate 23 with the imaging element 22 to provide an imaging device A (optical component) as shown in Fig. 4E. Further, this imaging device may be appropriately subjected to heat curing in the same manner as described above. Incidentally, in Fig. 4, the ultraviolet irradiation process shown in Fig. 4B may be omitted, and the resin composition may be cured by ultraviolet irradiation performed in Fig. 4D. Furthermore, in Fig. 4, in order to enhance sticking properties, a small amount of the transparent ultraviolet-curable resin composition 1 may be previously dropped on the imaging element 22 as shown in Fig. 5, before the transparent protecting plate cut to each piece shown in Fig. 4C is stuck onto the imaging element 22.

In Figs. 2, 3 and 4, the above-mentioned transparent ultraviolet-curable resin composition 1 is formed to the film on the transparent protecting plate 23, for example, by spin coating or a printing method. Further, when the predetermined film thickness is not obtained by one film-forming process, the resin composition is irradiated with the ultraviolet ray having a wavelength of 320 nm or more for each film formation to cure it, and this is repeated more than once, thereby being able to obtain the desired film thickness.

As the above-mentioned transparent ultraviolet-curable resin composition 1, a resin composition containing a thermosetting resin as a main component and a photo-acid generator is used, as previously described. The above-mentioned thermosetting resins include, for example, acrylic, acrylurethane-based, epoxy-based and silicone-based thermosetting resins. Above all, the epoxy-based thermosetting resin is preferably used from the viewpoints of adhesiveness, heat resistance and shrink properties. Additionally, in view of optical characteristics, the difference (|Dm-Dr|) between the refractive index (Dm) of a microlens mounted on the imaging element and the refractive index (Dr) of the cured product of the resin composition 1 is preferably 0.1 or more, and more preferably 0.2 or more.

Further, as the above-mentioned photo-acid generator, an agent which generates a cation-polymerizable acid by ultraviolet irradiation may be used. Such photo-acid generators include, for example, onium salts (diazonium salts, sulfonium salts, iodonium salts, selenium salts, pyridinium salts, ferrocenium salts, phosphonium salts and the like) containing anionic components such as SbF₆⁻, PF₆⁻, BF₄⁻, AsF₆⁻, (C₆F₅)₄⁻ and PF₄(CF₂CF₃)₂⁻ and cationic components. These photo-acid generators may be used alone or in combination thereof. Above all, from the viewpoints of curability and transparency, the onium salt having SbF₆⁻ or PF₄(CF₂CF₃)₂⁻ as the anionic component is preferably used. Further, as the above-mentioned onium salt, an aromatic sulfonium salt is preferred from the viewpoint of the rate of anion formation, and above all, particularly preferred is a triarylsulfonium salt from this viewpoint.

From the viewpoints of curability and adhesiveness, the content of the above-mentioned photo-acid generator is preferably within the range of 0.05 to 1.0 part by weight (hereinafter referred to as "part" for brevity), and particularly preferably within the range of 0.1 to 1.0 part, based on 100 parts of the above-mentioned thermosetting resin.

Incidentally, a silane-based or titanium-based adhesion promoter, a flexibility-imparting agent such as synthetic rubber or a polyorganosiloxane, an antioxidant, an defoaming agent, hydrocarbon-based wax, an inorganic filler or the like can be appropriately incorporated into the above-mentioned transparent ultraviolet-curable resin composition 1, according to the necessity.

As a light source used for the above-mentioned ultraviolet irradiation, a mercury lamp can be used. Further, an ultraviolet filter or a band-pass filter for preventing an ultraviolet ray having a wavelength of less than 320 nm from passing through can be used together with the mercury lamp as needed, because selective irradiation of the ultraviolet ray having a wavelength of 320 nm or more is required. Further, a semiconductor laser, an ultraviolet LED or the like may be used as the light source.

As the above-mentioned forming mold 13 or transparent protecting plate 23, one which is made of a transparent resin or glass and through which the ultraviolet ray having a wavelength of 320 nm or more is allowed to pass may be used. Specific materials therefor include various glass materials such as quartz glass, Pyrex (registered trade mark) glass and BK-7 (manufactured by Schott Glas), thermoplastic resins such as polyethylene, polypropylene, polymethyl methacrylate and polycarbonate, and materials which contain an epoxy resin, a polyimide resin, an acrylic resin or a silicone resin as a main component and are cured by heat or light to form a formed body. These are used alone or in combination thereof. Above all, polymethyl methacrylate or the silicone resin is preferred from the viewpoints of transparency, processability, heat resistance and light resistance.

Further, the above-mentioned forming mold 13 or transparent protecting plate 23 per se may be one having characteristics that it allows the ultraviolet ray having a wavelength of 320 nm or more to pass therethrough and prevents the ultraviolet ray having a wavelength of less than 320 nm from passing therethrough. That is to say, this is simpler than the irradiation of the ultraviolet ray having a wavelength of 320 nm or more through the filter, and when integrated with the cured product of the above-mentioned transparent ultraviolet-curable resin composition 1 as in the case of the transparent protecting plate 23, the problem of discoloration with time is hard to occur. This is therefore preferred. The above-mentioned forming mold 13 or transparent protecting plate 23 is preferably has an ultraviolet ray transmittance at a wavelength of less than 320 nm of less than 5%.

In order to prevent the ultraviolet ray having a wavelength of less than 320 nm, a benzophenone-based, benzotriazole-based, benzoate-based, salicylate-based or cyanoacrylate-based ultraviolet absorber or a hindered phenol-based, hindered amine-based, phosphorus-based or sulfur-based antioxidant may be incorporated into a transparent resin which is a material for the above-mentioned forming mold 13 or transparent protecting plate 23. These ultraviolet absorbers and antioxidants may be used alone or in combination thereof.

Further, in order to prevent the ultraviolet ray having a wavelength of less than 320 nm from passing through, the above-mentioned forming mold 13 or transparent protecting plate 23 may have a sputtering layer composed of at least one of cerium oxide, titanium oxide and zinc oxide on a surface of the glass base.

Incidentally, when the substrate 12 in Fig. 1 is one which allows the ultraviolet ray having a wavelength of 320 nm or more to pass therethrough, similarly to the above-mentioned forming mold 13 or transparent protecting plate 23, the ultraviolet irradiation can be performed not only through the above-mentioned forming mold 13 but also through the substrate 12. Accordingly, the degree of freedom of the ultraviolet irradiation preferably increases. In this case, materials and the like for the above-mentioned substrate are the same as with the above-mentioned forming mold 13 or transparent protecting plate 23. In terms of satisfactorily curing the transparent ultraviolet-curable resin composition 1, it is preferred that the above-mentioned substrate has characteristics that it allows the ultraviolet ray having a wavelength of 320 nm or more to pass therethrough and prevents the ultraviolet ray having a wavelength of less than 320 nm from passing therethrough.

The optical component thus obtained has stable mechanical characteristics without, for example, any discoloration and deformation due to heat at the time of solder reflow, so that this method can be advantageously used, for example, even when the imaging devices are collectively mounted by solder flow.

### Examples

Examples will be described bellow together with Comparative Examples. However, the invention should not be limited to these Examples.

Firstly, ultraviolet filters (A) to (C), processing molds (I) and (II), transparent ultraviolet-curable resin compositions (α) and (β) and transparent protecting plates (a) to (c) shown below were prepared, prior to Examples and Comparative Examples.

Ultraviolet Filters (A) to (C)
(A) UV-37 (An ultraviolet ray having a wavelength of 350 nm or less is cut off; an ultraviolet ray transmittance at a wavelength of 320 nm: 0%) manufactured by Toshiba Glass Co., Ltd.
(B) IRM (An ultraviolet ray having a wavelength of 325 nm or less is cut off; an ultraviolet ray transmittance at a wavelength of 320 nm: 0%) manufactured by Toshiba Glass Co., Ltd.
(C) UV-33 (An ultraviolet ray having a wavelength of 300 nm or less is cut off; an ultraviolet ray transmittance at a wavelength of 320 nm: 13.5%) manufactured by Toshiba Glass Co., Ltd.

Processing Molds (I) and (II)

Using a two-component thermally curable silicone resin (manufactured by Shin-Etsu Chemical Co., Ltd., KER-2500) including a base compound and a curing agent, the base compound and the curing agent were mixed so that a weight ratio of (base compound / curing agent) is 1/1. This mixture was transfer molded using a predetermined mold at 150°C for 2 minutes to prepare a transparent silicone resin processing mold (I) having the same shape as that of the forming mold 13 shown in Fig. 1. On the other hand, 4 g of 9,10-dihydro-9-oxa-phosphaphenanthrene-10-oxide was previously melt-mixed with 100 g of the base compound of the above-mentioned thermally curable silicone resin at 100°C, and then, 100 g of the curing agent of the above-mentioned thermally curable silicone resin was added thereto, followed by mixing them at room temperature. The resulting mixture was transfer molded in the same manner as described above to prepare a processing mold (II) having the same shape as that of the above-mentioned processing mold. For these forming molds, the ultraviolet ray transmittance at a wavelength of 320 nm was measured by using a spectrophotometer (manufactured by Shimadzu Corporation, UV-3101PC). As a result, the transmittance of the processing mold (I) was 88% and the transmittance of the processing mold (II) was 3.2%.

Preparation of Transparent Ultraviolet-Curable Resin Composition (α)

Fifty grams of a bisphenol A type epoxy resin (manufactured by Japan Epoxy Resins Co., Ltd., Epicoat 827), 50 g of an alicyclic epoxy resin (manufactured by Daicel Chemical Industries, Ltd., CEL-2021P) and 0.5 g of t-butylhydroxytoluene (manufactured by Sumitomo Chemical Co., Ltd., Sumilizer BHT-R) were melt-mixed by heating at 80°C for 30 minutes, and thereafter, the resulting mixture was cooled to 50°C. Then, 4 g of a photo-acid generator (manufactured by SAN-APRO Ltd., CPI-101A) and 2 g of a coupling agent (manufactured by Shin-Etsu Chemical Co., Ltd., KBM-403) were added thereto, followed by further stirring and mixing at 50°C for 10 minutes, thereby preparing a transparent ultraviolet-curable resin composition (α).

Preparation of Transparent Ultraviolet-Curable Resin Composition (β)

Seventy grams of an alicyclic epoxy resin (manufactured by Daicel Chemical Industries, Ltd., Celoxide 202 1 P), 30 g of a hydrogenated bisphenol A type epoxy resin (manufactured by Japan Epoxy Resins Co., Ltd., YX-8000) and 0.5 g of t-butylhydroxytoluene (manufactured by Sumitomo Chemical Co., Ltd., Sumilizer BHT-R) were melt-mixed by heating at 80°C for 30 minutes, and thereafter, the resulting mixture was cooled to 50°C. Then, 4 g of a photo-acid generator (manufactured by SAN-APRO Ltd., CPI-101A) and 2 g of a coupling agent (manufactured by Shin-Etsu Chemical Co., Ltd., KBM-403) were added thereto, followed by further stirring and mixing at 50°C for 10 minutes, thereby preparing a transparent ultraviolet-curable resin composition (β).

Transparent Protecting Plates (a) to (c)
(a) A heat-resistant glass protecting plate having a thickness of 0.5 mm (manufactured by Schott Glas, TEMPAX Float)
(b) A transparent silicone resin protecting plate having a thickness of 1.0 mm which was obtained by mixing a base compound and a curing agent of a two-component thermally curable silicone resin (manufactured by Shin-Etsu Chemical Co., Ltd., SCR-1016) so that a weight ratio (base compound / curing agent) is 1/1, and transfer molding this mixture using a mold of 50 mm × 50 mm × 1mm in depth at 150°C for 2 minutes
(c) A transparent silicone resin protecting plate having a thickness of 1.0 mm which was obtained by previously melt-mixing 4 g of 9,10-dihydro-9-oxa-phosphaphenanthrene-10-oxide with 100 g of the base compound of the two-component thermally curable silicone resin (manufactured by Shin-Etsu Chemical Co., Ltd., SCR-1016) at 100°C, thereafter, adding 100 g of the curing agent of the above-mentioned thermally curable silicone resin, followed by mixing them at room temperature, and transfer molding the resulting mixture in the same manner as with the above (b).

Incidentally, for the above-mentioned transparent protecting plates (a) to (c), the ultraviolet ray transmittance at a wavelength of 320 nm was measured by using a spectrophotometer (manufactured by Shimadzu Corporation, UV-3101 PC). As a result, the transmittance of the transparent protecting plate (a) was 100%, the transmittance of the transparent protecting plate (b) was 88%, and the transmittance of the transparent protecting plate (c) was 3.2%.

### Example 1

Potting of the transparent ultraviolet-curable resin composition (α) was performed on a quartz glass substrate having a thickness of 0.5 mm, and thereafter, the processing mold (I) was pressed on the quartz glass substrate through the above-mentioned transparent ultraviolet-curable resin composition (α). Then, the ultraviolet filter (A) was placed on the processing mold (I), followed by irradiation of an ultraviolet ray from a mercury lamp at 10 mW for 800 seconds. Thereafter, the processing mold (I) was demolded to obtain a desired test piece (sample) (see Fig. 1).

### Examples 2 and 3 and Comparative Examples 1 and 2

Test pieces (samples) were prepared in the same manner as in Example 1 with the exception that the ultraviolet filter and the kind of processing mold were changed as shown in Table 1 described later.

For the test pieces of Examples 1 to 3 and Comparative Examples 1 and 2 thus obtained, changes in "transparency" due to thermal degeneration thereof were measured and evaluated, and the results thereof are shown together in Table 1 described below. For details, just after the preparation of the test piece (just after sample preparation), after the test piece was allowed to stand under an environment of 100°C for 1 hour (after 100°C × 1 hour), and after the test piece was allowed to stand under an environment of 100°C for 500 hours (after 100°C × 500 hours), the yellow index value (Y. I. value) of the test piece was measured in transparent mode by using a color computer (manufactured by Suga Test Instruments Co., Ltd., SM-T). When the value was less than 7, it was judged as "good", and when the value was 0.7 or more, it was judged as "poor".

**Table 1**

| | | | Example | | | Comparative Example | |
|---|---|---|---|---|---|---|---|
| | | | 1 | 2 | 3 | 1 | 2 |
| Processing Mold | | | I | I | II | I | I |
| Ultraviolet Filter | | | A | B | - | - | C |
| Transparency | Just after Preparation of Sample | YI. Value | 1.9 | 2.9 | 3.2 | 4.7 | 3.7 |
| | | Judgment | Good | Good | Good | Good | Good |
| | After 100°C × 1 hour | YI. Value | 2.3 | 4.8 | 4.6 | 18.3 | 16.4 |
| | | Judgment | Good | Good | Good | Poor | Poor |
| | After 100°C × 500 hours | Y.I. Value | 4.1 | 5.9 | 6.1 | 20.3 | 18.9 |
| | | Judgment | Good | Good | Good | Poor | Poor |

The results of Fig. 1 described above reveals that the products of Examples are excellent in suitability for an optical component because the resin molded products scarcely discolored are obtained even when they are allowed to stand under the environment of 100°C for 500 hours. Compared with this, the products of Comparative Examples are significantly discolored after standing under the environment of 100°C, so that they are poor in suitability for an optical component.

### Example 4

A 200-µm thick film of the transparent ultraviolet-curable resin composition (β) was formed on the transparent protecting plate (a) cut to a size of 50 mm × 50 mm, and then, the film of the resin composition was irradiated with the ultraviolet ray from a face of the protecting plate (a) through the ultraviolet filter (A) at 10 mW for 100 seconds. A surface of the film of the resin composition thus semicured was stuck onto the heat-resistant glass having a size of 50 mm × 50 mm, followed by pressing it on the glass with a pressing machine. Then, the film of the resin composition was irradiated with the ultraviolet ray from the face of the protecting plate (a) through the ultraviolet filter (A) at 10 mW for 300 seconds. Thereafter, the film was heat curing at 100°C for 1 hour, and then, cut to a size of 20 mm in width and 30 mm in length to prepare a test piece (see Fig. 3).

### Examples 5 and 6 and Comparative Examples 3 and 4

Test pieces (samples) were prepared in the same manner as in Example 4 with the exception that the ultraviolet filter and the kind of transparent protecting plate were changed as shown in Table 2 described later.

For the test pieces of Examples 4 to 6 and Comparative Examples 3 and 4 thus obtained, changes in "transparency" due to thermal degeneration thereof were measured and evaluated, and the results thereof are shown together in Table 2 described below. For details, just after the preparation of the test piece (just after sample preparation), after the test piece was allowed to stand under an environment of 100°C for 1 hour (after 100°C × 1 hour), and after the test piece was allowed to stand under an environment of 100°C for 500 hours (after 100°C × 500 hours), the yellow index value (Y. I. value) of the test piece was measured in transparent mode by using a color computer (manufactured by Suga Test Instruments Co., Ltd., SM-T). When the value was less than 7, it was judged as "good", and when the value was 0.7 or more, it was judged as "poor".

**Table 2**

| | | | Example | | | Comparative Example | |
|---|---|---|---|---|---|---|---|
| | | | 4 | 5 | 6 | 3 | 4 |
| Ultraviolet Filter | | | A | B | - | C | - |
| Transparent Protecting Plate | | | a | b | c | - | b |
| Transparency | Just after Preparation of Sample | Y.I. Value | 1.3 | 2.1 | 1.8 | 5.8 | 4.2 |
| | | Judgment | Good | Good | Good | Good | Good |
| | After 100°C × 1 hour | Y.I. Value | 1.9 | 2.8 | 2.3 | 9.3 | 7.4 |
| | | Judgment | Good | Good | Good | Poor | Poor |
| | After 100°C × 500 hours | Y.I. Value | 2.1 | 3.2 | 2.9 | 10.1 | 8.7 |
| | | Judgment | Good | Good | Good | Poor | Poor |

The results of Fig. 2 described above reveals that the products of Examples are excellent in suitability for an optical component because the products are scarcely discolored even when they are allowed to stand under the environment of 100°C for 500 hours. Compared with this, the products of Comparative Examples are significantly discolored after standing under the environment of 100°C, so that they are poor in suitability for an optical component.

The above results reveal that according to the process for producing an optical component of the invention, the optical component having high transparency and heat resistance reliability without resin discoloration could be simply produced.

Incidentally, even when the optical component was produced by the process shown in Fig. 2 or the process shown in Fig. 4 (including the process shown in Fig. 5), the same results as in Examples were obtained.

While the invention has been described in detail and with reference to specific embodiments thereof, it will be apparent to one skilled in the art that various changes and modifications can be made therein without departing from the spirit and scope thereof.

This application is based on Japanese Patent Applications (Patent Application No. 2008-157938) filed on June 17, 2008, the entirety of which is incorporated herein by way of reference.

All references cited herein are incorporated by reference herein in their entirety.

## Claims

1. A process for producing an optical component, said process comprising:
disposing a transparent stamp tool on a substrate or an imaging element through a transparent ultraviolet-curable resin composition layer; and
irradiating said resin composition layer with an ultraviolet ray through the transparent stamp tool to thereby cure said resin composition layer,
wherein a resin composition contained in said resin composition layer contains a thermosetting resin as a main component and a photo-acid generator, and the ultraviolet ray passing through the transparent stamp tool is an ultraviolet ray having a wavelength of 320 nm or more.

2. The process for producing an optical component according to claim 1, wherein the transparent stamp tool is a forming mold in which a mold surface thereof has a concave-convex pattern, and wherein the transparent ultraviolet-curable resin composition layer is cured by irradiation of the ultraviolet ray, and then, the concave-convex pattern is transferred to said resin composition layer by demolding the forming mold.

3. The process for producing an optical component according to claim 1, wherein the transparent stamp tool is a transparent protecting plate for the imaging element, and wherein the transparent ultraviolet-curable resin composition layer is cured by irradiation of the ultraviolet ray, and the imaging element is integrated with the transparent protecting plate by curing said resin composition layer.

4. The process for producing an optical component according to any one of claims 1 to 3, wherein the transparent stamp tool allows an ultraviolet ray having a wavelength of 320 nm or more to pass therethrough and prevents an ultraviolet ray having a wavelength of less than 320 nm from passing therethrough.

5. The process for producing an optical component according to claim 4, wherein the transparent stamp tool has an ultraviolet ray transmittance at a wavelength of less than 320 nm of less than 5%.

6. The process for producing an optical component according to any one of claims 1 to 5, wherein the transparent stamp tool is composed of a silicone resin or polymethyl methacrylate.

7. The process for producing an optical component according to any one of claims 1 to 6, wherein the transparent stamp tool is composed of a transparent resin containing at least one of an ultraviolet absorber and an antioxidant.

8. The process for producing an optical component according to any one of claims 1 to 5, wherein the transparent stamp tool comprises a glass base, and a sputtering layer provided on a surface of the glass base and composed of at least one of cerium oxide, titanium oxide and zinc oxide.

9. The process for producing an optical component according to any one of claims 1 to 8, wherein the substrate is a transparent substrate, and the transparent ultraviolet-curable resin composition layer is irradiated with the ultraviolet ray having a wavelength of 320 nm or more through the transparent substrate.

10. The process for producing an optical component according to of claim 9, wherein the transparent substrate allows an ultraviolet ray having a wavelength of 320 nm or more to pass therethrough and prevents an ultraviolet ray having a wavelength of less than 320 nm from passing therethrough.

11. The process for producing an optical component according to any one of claims 1 to 10, wherein the transparent ultraviolet-curable resin composition layer is cured by irradiation of the ultraviolet ray, and then, the cured product is subjected to heat treatment at 70°C or more.
